(19) 

Europäisches
Patentamt
European
Patent Office
Office européen
des brevets

(11) **EP 2 234 161 A1**

(12) **EUROPEAN PATENT APPLICATION**
published in accordance with Art. 153(4) EPC

(43) Date of publication:
**29.09.2010 Bulletin 2010/39**

(21) Application number: **08873826.5**

(22) Date of filing: **10.11.2008**

(51) Int Cl.:
***H01L 27/148*** *(2006.01)*  ***H01L 27/14*** *(2006.01)*
***H01L 27/00*** *(2006.01)*

(86) International application number:
**PCT/CN2008/001865**

(87) International publication number:
**WO 2009/124427 (15.10.2009 Gazette 2009/42)**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **10.04.2008 CN 200810050583**

(71) Applicant: **Changchun Institute of Optics, Fine
Mechanics and
Physics, Chinese Academy of Sciences
Jilin 130033 (CN)**

(72) Inventors:
• **ZHAI, Linpei**
  **Jilin 130033 (CN)**
• **DING, Yalin**
  **Jilin 130033 (CN)**
• **ZHAI, Yan**
  **Jilin 130033 (CN)**

(74) Representative: **Bongiovanni, Simone et al
STUDIO TORTA
Via Viotti 9
10121 Torino (IT)**

(54) **A CCD PIXEL WITH A GEOMETRY WHICH CAN INCREASE RESOLUTION**

(57)     The present invention relates to the filed of fabrication and application of CCD devices, and provides a CCD pixel element with a geometry capable of improving a resolution of a CCD device having such pixel element. According to the present invention, a conventional CCD pixel element is divided into four sub-regions having same areas by two intersecting straight lines or cures with an intersection point positioned within the pixel element, and one of the sub-regions is removed so as to form the CCD pixel element geometry. It is possible to improve a resolution of a CCD device having pixel elements with such geometry.

Fig. 4

EP 2 234 161 A1

**Description**

**BACKGROUND OF THE INVENTION**

**FIELD OF INVENTION**

The present invention relates to the field of fabrication and application of CCD devices, and more particularly, to a CCD pixel element with a geometry capable of improving a resolution of a CCD device having such pixel element.

**DESCRIPTION OF PRIOR ART**

CCD devices have found wide applications in various photoelectric imaging systems, and become a typical receiving and imaging device for modern optical information transfer, with a resolution determined by geometry and size of pixel elements thereof. The size of a CCD pixel element is limited by lots of conditions, and thus it is impossible to reduce the size of a CCD pixel element without limit to improve the resolution a CCD device having such pixel element. Focuses have been placed on how to improve the resolution of a CCD device in the art of study, manufacture, and application of CCD devices.
In prior art, it is known that a pixel element of a conventional CCD device is usually formed in a regular geometry such as square, rectangle, or octagon. It is very difficult to improve the resolution of a CCD device having CCD pixel elements with such regular geometry.

**SUMMARY OF THE INVENTION**

An object of the present invention is to provide a CCD pixel element with a novel geometry to improve a resolution of a CCD device having such pixel element, so as to overcome the limits of the prior art.
In order to achieve the above object, according to an aspect of the invention, there is provided a CCD pixel element with a geometry capable of improving a resolution of a CCD device having such pixel element, wherein a conventional CCD pixel element is divided into four sub-regions having same areas by two intersecting straight lines or cures with an intersection point positioned within the pixel element, and one of the sub-regions is removed so as to form the CCD pixel element geometry according to the present invention.

Principle

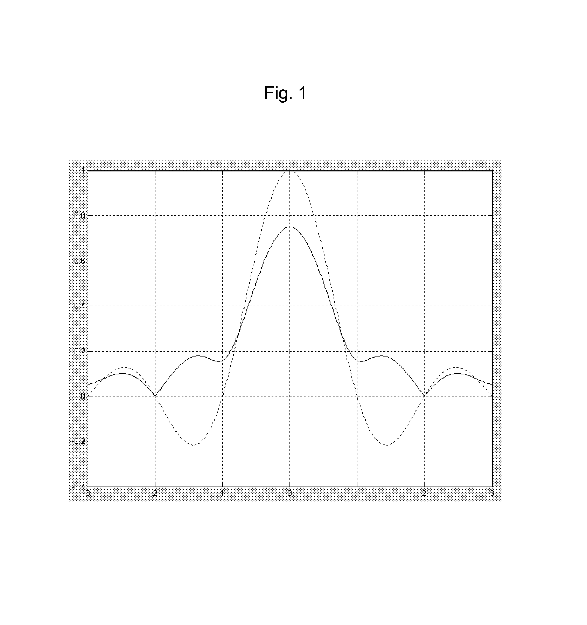

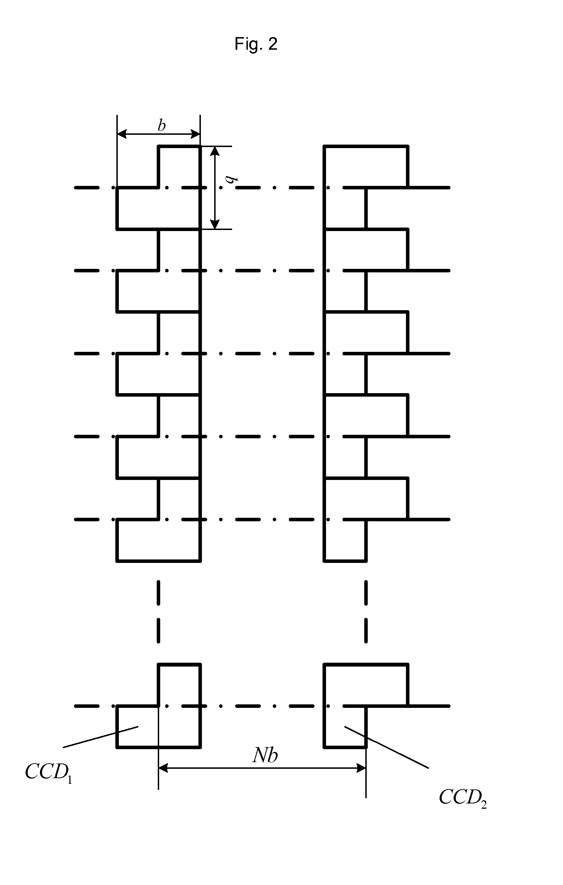

Fig. 1 shows two graphs, the dashed line representing a frequency profile for a conventional CCD pixel element in a square shape, and the solid line representing a frequency profile for a CCD pixel element with one sub-region removed as described above. As can be seen from the drawing, a bandwidth of the graph representing the frequency profile for the CCD pixel element with one sub-region removed is two times greater than that of the graph representing the frequency profile for the conventional CCD pixel element in a square shape. In other words, the resolution is improved.
The CCD pixel element with one sub-region removed may be used in the same way as the conventional one, and also may be used differently. For example, Fig. 2 shows two line array CCD devices having pixel elements with sub-regions removed, the left one having a pixel element geometry obtained by removing an upper left sub-region from a conventional square pixel element as described above, and the right one having a pixel element geometry obtained by removing a lower right sub-region from a conventional square pixel element as described above. The pixel element geometry differs as the position of the removed sub-region differs, but is just obtained by removing one sub-region from a square pixel element as described above.
These two line array CCD devices are spaced from each other by N pixel elements, where N is an integer. Each pixel element of the left line array CCD device corresponds to and is aligned with a respective one of the right line array CCD device, as shown by the dashed lines in Fig. 2. It is possible to achieve this structure by integrating these two line array CCD devices onto one same substrate, or by other means such as optical means.

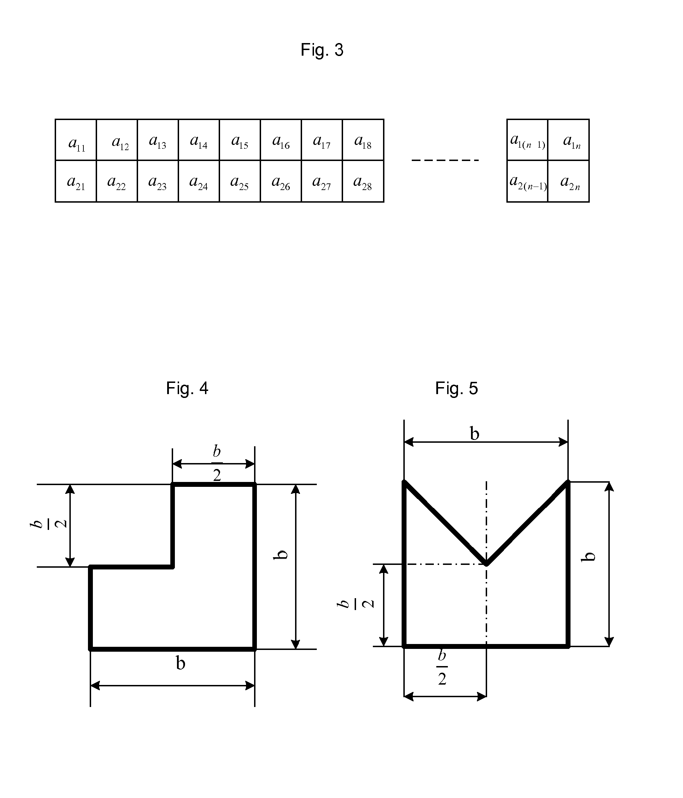

Let the left one be $CCD_1$ and the right one be $CCD_2$, both having a sampling step of $\dfrac{b}{2}$ , where b is the side length of an original square pixel element. After 2N times of sampling, the sampling position for $CCD_2$ is same as that for $CCD_1$. Since all pixel elements of $CCD_1$ and $CCD_2$ are subject to the same procedure, just one pixel element is described in detail for illustration. During sampling, an image signal captured by a sub-region of a pixel element is denoted by $ai_j$, as shown in Fig. 3.
Let an output from a pixel element of $CCD_1$ be $y_k$, and an output from a pixel element of $CCD_2$ be $x_k$. It may

be considered that three sub-regions of each CCD pixel element contribute to an output from this pixel element. Thus, the following equations can be obtained:

$$y_1 = a_{12} + a_{21} + a_{22} \qquad x_1 = a_{11} + a_{12} + a_{21}$$
$$y_2 = a_{13} + a_{22} + a_{23} \qquad x_2 = a_{12} + a_{13} + a_{22}$$
$$\vdots \qquad\qquad\qquad \vdots$$
$$\vdots \qquad\qquad\qquad \vdots$$
$$y_n = a_{1n} + a_{2(n-1)} + a_{2n} \qquad x_n = a_{1(n-1)} + a_{1n} + a_{2(n-1)}$$

From the above set of equations, it can be seen that the number of unknowns is equal to the number of the equations plus 2. If evaluation values for two unknowns are given (there are many ways to give an evaluation value for an unknown), then the set of equations can be solved. As a result, it is possible to achieve subdivision of pixel elements by a factor of 2, and thus to improve the imaging resolution.

Advantages

According to the present invention, a conventional CCD pixel element is divided into four sub-regions having same areas and one of the sub-regions is removed so as to obtain a pixel element geometry of the invention. It is possible to improve a resolution of a CCD device with such pixel element geometry.

**BRIEF DESCRIPTION OF THE DRAWINGS**

Fig.1 is a schematic diagram showing a frequency profile for a square CCD pixel element vs. a frequency profile for a CCD pixel element with one sub-region removed;

Fig. 2 is a schematic diagram showing an application of two line array CCD devices having respective square pixel elements with respective sub-regions removed;

Fig. 3 is a schematic diagram showing $a_{ij}$ indicating outputs from sub-regions of the line array CCD devices;

Fig. 4 is a schematic diagram showing a CCD pixel element geometry where an upper left sub-region is removed from a square pixel element;

Fig. 5 is a schematic diagram showing a CCD pixel element geometry where a sub-region defined by two diagonals and facing an upper side is removed from a square pixel element;

Fig. 6 is a schematic diagram showing a CCD pixel element geometry where an lower right sub-region is removed from a rectangle pixel element;

Fig. 7 is a schematic diagram showing a CCD pixel element geometry where a sub-region defined by two diagonals and facing a right long side is removed from a rectangle pixel element;

Fig. 8 is a schematic diagram showing a CCD pixel element geometry where an upper left sub-region is removed from an octagon pixel element; and

Fig. 9 is a schematic diagram showing a CCD pixel element geometry where a sub-region defined by two diagonals is removed from an octagon pixel element.

**DETAILED DESCRIPTION OF PREFERRED EMBODIMENTS**

According to embodiments of the present invention, there are many geometries that can be obtained by dividing a conventional CCD pixel element into four sub-regions having same areas by two intersecting straight lines or cures with an intersection point positioned within the pixel element and removing one of the sub-regions from the CCD pixel element. Hereinafter, examples are described with reference to Figs. 4 - 9.

Example 1

Fig. 4 is a schematic diagram showing a CCD pixel element geometry where an upper left sub-region is removed from a square pixel element, where b indicates a side length of the square pixel element. Such pixel element geometry is obtained by dividing the square pixel element into four sub-regions having same areas by two intersecting straight lines, which are perpendicular to each other and are perpendicular to sides of the pixel element respectively, with an intersection point positioned at the center of the pixel element, and removing the upper left sub-region from the pixel element. Alternatively, any other sub-region may be removed according to practical applications.

Example 2

Fig. 5 is a schematic diagram showing a CCD pixel element geometry where a sub-region defined by two diagonals and facing an upper side is removed from a square pixel element, where b indicates a side length of the square pixel element. Such pixel element geometry is obtained by dividing the square pixel element into four sub-regions having same areas by two intersecting straight lines, which are perpendicular to each other and overlap diagonals of the square pixel element respectively, with an intersection point positioned at the center of the pixel element, and removing the upper sub-region from the pixel element. Alternatively, any other sub-region may be removed according to practical applications.

Example 3

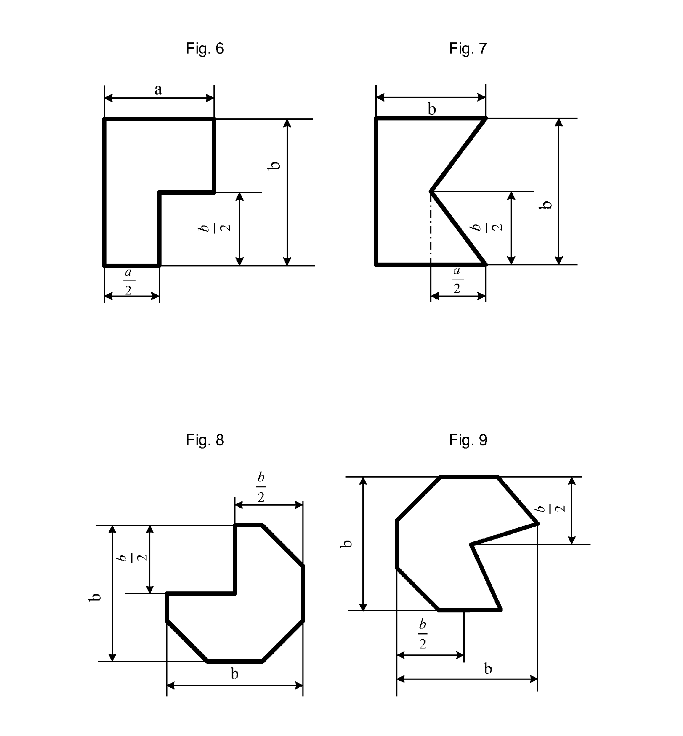

Fig. 6 is a schematic diagram showing a CCD pixel element geometry where a lower right sub-region is removed from a rectangle pixel element, where b indicates a long side and a indicates a short side. Such pixel element geometry is obtained by dividing the rectangle pixel element into four sub-regions having same areas by two intersecting straight lines, which are perpendicular to each other and are perpendicular to sides of the pixel element respectively, with an intersection point positioned within the pixel element, and removing the lower right sub-region from the pixel element. Alternatively, any other sub-region may be removed according to practical applications.

Example 4

Fig. 7 is a schematic diagram showing a CCD pixel element geometry where a sub-region defined by two diagonals and facing a right long side is removed from a rectangle pixel element, where b indicates a long side and a indicates a short side. Such pixel element geometry is obtained by dividing the rectangle pixel element into four sub-regions having same areas by two diagonals passing through the center of the rectangle pixel element, and removing the sub-region facing the right long side from the pixel element. Alternatively, any other sub-region may be removed according to practical applications.

Example 5

Fig. 8 is a schematic diagram showing a CCD pixel element geometry where an upper left sub-region is removed from an octagon pixel element, where b indicates a distance between two opposing sides. Such pixel element geometry is obtained by dividing the octagon pixel element into four sub-regions having same areas by two intersecting straight lines, which pass through the center of the octagon pixel element and are perpendicular to opposing sides of the octagon pixel element respectively, and removing the upper left sub-region from the pixel element. Alternatively, any other sub-region may be removed according to practical applications.

Example 6

Fig. 9 is a schematic diagram showing a CCD pixel element geometry where a sub-region defined by two diagonals is removed from an octagon pixel element, where b indicates a distance between two opposing sides. Such pixel element geometry is obtained by dividing the octagon pixel element into four sub-regions having same areas by two diagonals connecting opposing corners of the octagon pixel element respectively, and removing the lower right sub-region from the pixel element. Alternatively, any other sub-region may be removed according to practical applications.

Although in the above embodiments all the geometries are obtained by dividing a conventional CCD pixel element into four sub-regions having same areas by two straight lines, which are provided just for simple illustration, the conventional CCD pixel may be divided into four sub-regions having same areas by two curves. Further, those skilled in the art can conceive modifications to above examples 1 - 6. All those modifications should be considered as falling into the scope of the invention which is defined by appending claims.

**Claims**

1. A CCD pixel element with a geometry capable of improving a resolution of a CCD device having such pixel element, wherein a conventional CCD pixel element is divided into four sub-regions having same areas by two intersecting straight lines or cures with an intersection point positioned within the pixel element, and one of the sub-regions is removed so as to form the geometry.

2. The CCD pixel element according to claim 1, wherein the geometry is obtained by dividing a conventional square pixel element into four sub-regions having same areas by two intersecting straight lines, which pass through a center of the square pixel element and are perpendicular to sides of the square pixel element respectively, and removing one of the sub-regions from the pixel element.

3. The CCD pixel element according to claim 1, wherein the geometry is obtained by dividing a conventional square pixel element into four sub-regions having same areas by two intersecting straight lines, which pass through a center of the square pixel element and overlap diagonals of the square pixel element respectively, and removing one of the sub-regions from the pixel element.

4. The CCD pixel element according to claim 1, wherein the geometry is obtained by dividing a conventional rectangle pixel element into four sub-regions having same areas by two intersecting straight lines, which pass through a center of the rectangle pixel element and are perpendicular to sides of the rectangle pixel element respectively, and removing one of the sub-regions from the pixel element.

5. The CCD pixel element according to claim 1, wherein the geometry is obtained by dividing a conventional rectangle pixel element into four sub-regions having same areas by two intersecting straight lines, which pass through a center of the rectangle pixel element and overlap diagonals of the rectangle pixel element respectively, and removing one of the sub-regions from the pixel element.

6. The CCD pixel element according to claim 1, wherein the geometry is obtained by dividing a conventional octagon pixel element into four sub-regions having same areas by two intersecting straight lines, which pass through a center of the octagon pixel element and are perpendicular to opposing sides of the octagon pixel element respectively, and removing one of the sub-regions from the pixel element.

7. The CCD pixel element according to claim 1, wherein the geometry is obtained by dividing a conventional octagon pixel element into four sub-regions having same areas by two intersecting straight lines, which pass through a center of the octagon pixel element and connect opposing corners of the octagon pixel element respectively, and removing one of the sub-regions from the pixel element.

Fig. 1

Fig. 2

Fig. 3

| $a_{11}$ | $a_{12}$ | $a_{13}$ | $a_{14}$ | $a_{15}$ | $a_{16}$ | $a_{17}$ | $a_{18}$ | | $a_{1(n-1)}$ | $a_{1n}$ |
|---|---|---|---|---|---|---|---|---|---|---|
| $a_{21}$ | $a_{22}$ | $a_{23}$ | $a_{24}$ | $a_{25}$ | $a_{26}$ | $a_{27}$ | $a_{28}$ | | $a_{2(n-1)}$ | $a_{2n}$ |

Fig. 4

Fig. 5

Fig. 6

Fig. 7

Fig. 8

Fig. 9

# INTERNATIONAL SEARCH REPORT

| International application No. |
| --- |
| PCT/CN2008/001865 |

**A. CLASSIFICATION OF SUBJECT MATTER**

See extra sheet

According to International Patent Classification (IPC) or to both national classification and IPC

**B. FIELDS SEARCHED**

Minimum documentation searched (classification system followed by classification symbols)
IPC: H01L27/148, 27/14, 27/00, 27/146, 27/144, H01L21/339, H04N 5/335, 5/33, 5/30, 5/00, 3/14, 9/04, 9/083

Documentation searched other than minimum documentation to the extent that such documents are included in the fields searched

Electronic data base consulted during the international search (name of data base and, where practicable, search terms used)
CNPAT, CNKI, WPI, EPODOC, PAJ: charge w couple+ w device, CCD, resolution, pixel, shape, geometry, area, intersect+

**C. DOCUMENTS CONSIDERED TO BE RELEVANT**

| Category* | Citation of document, with indication, where appropriate, of the relevant passages | Relevant to claim No. |
| --- | --- | --- |
| PX | CN101257034A (CHANGCHUN INSTITUTE OF OPTICS，FINE MECHANICS AND PHYSICS，CHINESE ACADEMY OF SCIENCES) 03 Sep. 2008 (03.09.2008) The whole document | 1-7 |
| A | JP2001309122A (NIPPONDENSO CO LTD) 02 Nov. 2001 (02.11.2001) The whole document | 1-7 |
| A | JP2007035837A (TOPPAN PRINTING CO LTD) 08 Feb. 2007 (08.02.2007) The whole document | 1-7 |
| A | US2007/0012861A1 (FUJI PHOTO FILM CO LTD) 18 Jan. 2007 (18.01.2007) The whole document | 1-7 |
| A | JP2006303407A (FUJI PHOTO FILM CO LTD) 02 Nov. 2006 (02.11.2006) The whole document | 1-7 |
| A | US6388278B1 (FUJI PHOTO FILM CO LTD) 14 May. 2002 (14.05.2002) The whole document | 1-7 |
| A | US5956087A (CANON KK) 21 Sep. 1999 (21.09.1999) The whole document | 1-7 |

☐ Further documents are listed in the continuation of Box C.  ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim (S) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&"document member of the same patent family |

| Date of the actual completion of the international search | Date of mailing of the international search report |
| --- | --- |
| 15. Jan. 2009 (15.01.2009) | **22 Jan. 2009 (22.01.2009)** |
| Name and mailing address of the ISA/CN<br>The State Intellectual Property Office, the P.R.China<br>6 Xitucheng Rd., Jimen Bridge, Haidian District, Beijing, China 100088<br>Facsimile No. 86-10-62019451 | Authorized officer<br>ZHANG Chunwei<br>Telephone No. (86-10)62414346 |

Form PCT/ISA/210 (second sheet) (April 2007)

## INTERNATIONAL SEARCH REPORT
### Information on patent family members

| International application No. |
|---|
| PCT/CN2008/001865 |

| Patent Documents referred in the Report | Publication Date | Patent Family | Publication Date |
|---|---|---|---|
| CN101257034A | 03.09.2008 | None | |
| JP2001-309122A | 02.11.2001 | None | |
| JP2007-35837A | 08.02.2007 | None | |
| US2007/0012861A1 | 18.01.2007 | JP2007-019251A | 25.01.2007 |
| JP2006-303407A | 02.11.2006 | None | |
| US6388278B1 | 14.05.2002 | JP2001-168315A | 22.06.2001 |
| US5956087A | 21.09.1999 | JP9-130537A | 16.05.1997 |
| | | JP3143053B2 | 07.03.2001 |

Form PCT/ISA/210 (patent family annex) (April 2007)

# INTERNATIONAL SEARCH REPORT

International application No.

PCT/CN2008/001865

A. CLASSIFICATION OF SUBJECT MATTER:

H01L 27/148 (2006.01) i

H01L 27/14 (2006.01) i

H01L 27/00 (2006.01) i

Form PCT/ISA/210 (extra sheet) (April 2007)